# EUROPÄISCHE PATENTSCHRIFT

(11) **EP 1 771 895 B1**
(45) Veröffentlichungstag und Bekanntmachung des Hinweises auf die Patenterteilung: **08.06.2016**
(21) Anmeldenummer: 05778553.7
(22) Anmeldetag: 12.07.2005
(51) Int. Cl.: H01L 51/52

(54) **TOP-EMITTIERENDES, ELEKTROLUMINESZIERENDES BAUELEMENT MIT ZUMINDEST EINER ORGANISCHEN SCHICHT**
TOP-EMITTING, ELECTROLUMINESCENT COMPONENT HAVING AT LEAST ONE ORGANIC LAYER
COMPOSANT ELECTROLUMINESCENT A EMISSION PAR LA SURFACE, COMPORTANT AU MOINS UNE COUCHE ORGANIQUE

(30) Priorität: 23.07.2004 DE 102004035965
(43) Veröffentlichungstag der Anmeldung: 11.04.2007
(73) Patentinhaber: Novaled GmbH, 01307 Dresden (DE)
(72) Erfinder: VEHSE, Martin, 27777 Ganderkesee (DE); ROMAINCZYK, Tilmann, 01099 Dresden (DE); BIRKNSTOCK, Jan, 01187 Dresden (DE)
(74) Vertreter: Bittner, Thomas L.
(86) Internationale Anmeldenummer: PCT/DE2005/001229
(87) Internationale Veröffentlichungsnummer: WO 2006/010355

(56) Entgegenhaltungen:
- EP-A- 1 406 474
- EP-A- 1 434 283
- WO-A-00/76008
- WO-A-02/37580
- US-A1- 2001 026 124
- US-A1- 2001 035 713
- US-A1- 2002 015 807
- US-A1- 2003 111 666
- US-A1- 2003 127 973
- PFEIFFER M ET AL: "DOPED ORGANIC SEMICONDUCTORS: PHYSICS AND APPLICATION IN LIGHT EMITTING DIODES" ORGANIC ELECTRONICS, ELSEVIER, AMSTERDAM, NL, Bd. 4, Nr. 2/3, September 2003 (2003-09), Seiten 89-103, XP001177135 ISSN: 1566-1199

## Beschreibung

Die Erfindung betrifft ein top-emittierendes, elektrolumineszierendes Bauelement nach Anspruch 1 sowie ein Verfahren zu dessen Herstellung nach Anspruch 11.

In den letzten Jahren hat sich ein großer Bedarf nach immer kleineren, platzsparenden, leichten und kostengünstigen Anzeigemodulen und Displays zur schnellen und adäquaten Visualisierung von Daten entwickelt. Auf dem Gebiet der Flachbildschirme für Notebooks, Mobiltelefone und Digitalkameras sind derzeit noch LCDs (Liquid Crystal Displays) vorherrschend. Diese weisen jedoch einige Nachteile auf, wie die starke Winkelabhängigkeit von Kontrast und Farben, langsame Ansprechzeiten bei Bild- und Kontrastwechsel und eine durch eine Vielzahl von Filtern und Polarisatoren bedingte geringe Effizienz, sodass zur Erzielung der benötigten Leuchtstärke verhältnismäßig hohe Energien eingesetzt werden müssen. Insofern ist die Nachfrage nach kleinen hochauflösenden, farbigen und stromsparenden Bildschirmen mit verbesserten Darstellungseigenschaften groß. Displays auf der Basis von organischen Leuchtdioden (organic light emitting diodes: OLEDs) stellen eine Alternative zu LCDs dar, da sie selbst aus lichtemittierenden Pixeln bestehen und somit keine Hintergrundbeleuchtung aufweisen. Sie sind beispielsweise in Form einer Folie flexibel und dünn mit geringen Produktionskosten herstellbar und mit einem verhältnismäßig geringen Energieaufwand betreibbar. Mit ihrer niedrigen Betriebsspannung, der hohen Energieeffizienz sowie der Möglichkeit flächig emittierender Bauelemente zur Emission von beliebigen Farben herzustellen, eignen sich OLEDs auch für die Anwendung in Beleuchtungselementen.

OLEDs beruhen auf dem Prinzip der Elektrolumineszenz, bei welcher Elektron-Loch-Paare, sogenannte Exzitonen unter Aussendung von Licht rekombinieren. Hierzu ist die OLED in Form einer Sandwichstruktur aufgebaut, bei welcher zumindest ein organischer Film als aktives Material zwischen zwei Elektroden angeordnet ist, wobei positive und negative Ladungsträger in das organische Material injiziert werden, ein Ladungstransport von Löchern beziehungsweise Elektroden zu einer Rekombinationszone in der organischen Schicht stattfindet, wo eine Rekombination der Ladungsträger zu Singulett- und/oder Triplett-Exzitonen unter Lichtemission auftritt. Die nachfolgende strahlende Rekombination der Exzitonen verursacht die Emission des sichtbaren Nutzlichtes, das von der Leuchtdiode emittiert wird. Damit dieses Licht das Bauelement verlassen kann, muss zumindest eine der Elektroden transparent sein. In der Regel besteht diese transparente Elektrode aus leitfähigen Oxiden, welche als TCOs (transparent conductive oxides) bezeichnet werden. Ausgangspunkt bei der Herstellung einer OLED ist ein Substrat, auf welches die einzelnen Schichten des OLEDs aufgebracht werden. Ist die zum Substrat nächstgelegene Elektrode transparent, wird das Bauelement als "bottom-emission-OLED" bezeichnet, ist die andere Elektrode transparent ausgeführt, wird das Bauelement als "top-emission-OLED" bezeichnet. Gleiches gilt für den Fall volltransparenter OLEDs, bei denen sowohl die Elektrode zwischen Substrat und der zumindest einen organischen Schicht als auch die zum Substrat entfernt gelegene Elektrode transparent ausgeführt sind.

Wie erläutert, erfolgt die Erzeugung des Lichtes in der aktiven Zone oder Emissionszone des Bauelementes durch strahlende Rekombination von Elektronen und Defektelektronen (Löcher) über exzitonische Zustände. Die unterschiedlichen Schichten der OLEDs, beispielsweise die transparenten Elektroden und die wenigstens eine organische Schicht weisen im allgemeinen einen unterschiedlichen Brechungsindex auf, welcher naturgemäß größer 1 ist. Insofern können nicht alle erzeugten Photonen das Bauteil verlassen und als Licht wahrgenommen werden, da an den verschiedenen Grenzflächen innerhalb des Bauteils beziehungsweise zwischen dem Bauteil und der Luft Totalreflexionen auftreten können. Darüber hinaus wird auch ein Teil des erzeugten Lichtes wieder innerhalb des Bauteils absorbiert. Je nach Bauart der OLEDs kommt es neben der Ausbreitung von externen Moden, aufgrund der zuvor beschriebenen Totalreflexion, zur Ausbildung optischer Substrat- und/oder Organik-Moden (d.h. Lichtausbreitung im Substrat, der transparenten Elektrode und/oder der zumindest einen organischen Schicht). Ist die zum Substrat nächstgelegene Elektrode nicht transparent (top-emission-OLED), können sich neben externen Moden lediglich Moden in der zumindest einen organischen Schicht und/oder der zum Substrat entfernt gelegenen Elektrode ausbreiten, welche gemeinsam als Organik-Moden bezeichnet werden. Nur die externen optischen Moden können vom Betrachter als Licht wahrgenommen werden, wobei deren Anteil zur gesamten erzeugten Lumineszenz innerhalb des Bauteils je nach Bauart der OLED kleiner 20 % liegt. Insofern besteht ein Bedarf, diese internen optischen Moden, d.h. Organik- und gegebenenfalls Substratmoden stärker aus dem Bauteil auszukoppeln um einen möglichst hohen Wirkungsgrad des organischen lichtemittierenden Bauteils zu erreichen.

Zur Verbesserung der Auskoppeleffizienz sind eine Vielzahl von Verfahren und Gestaltungen insbesondere für bottom-emittierende OLEDs bekannt, die sich mit der Auskopplung der optischen Substratmoden beschäftigen. Hierzu wird in dem Artikel "30 % external quantum efficiency from surface textured, thin-film light-emitting diodes" von I. Schnitzer, Appl. Phys. Lett., Bd. 63, Seite 2174 (1993) vorgeschlagen, die Oberfläche des Substrates aufzurauen, wodurch in einem erheblichen Umfang das Auftreten von Totalreflexion an der Grenzfläche zwischen Substrat und Luft vermieden wird. Diese Aufrauung kann beispielsweise durch Ätzen oder Sandstrahlen der Substratfläche erreicht werden, welche zur Organik abgewandt ist. In dem Beitrag "Improvement of output coupling efficiency of organic light-emitting diodes by backside substrate modification", von C.F. Madigan, Appl. Phys. Lett., Bd. 76, Seite 1650 (2000) wird das Aufbringen eines sphärischen Musters auf die Rückseite der Substratoberfläche beschrieben. Dieses Muster kann beispielsweise ein Array von Linsen umfassen, welches durch Kleben oder Laminieren auf das Substrat aufgebracht wird. In dem Artikel "Organic light emitting device with an ordered monolayer of silica microspheres as a scattering medium" von T. Yamasaki et al, Appl. Phys. Lett., Band 76, Seite 1243 (2000) wird vorgeschlagen, Mikrokugeln aus Quarzglas auf die Oberfläche des Substrates aufzubringen um die Auskopplung des Lichtes bei einer OLED zu verbessern. Diese Mikrokugeln können auch neben der OLED angeordnet sein. Darüber hinaus ist auch bekannt, periodische Strukturen mit einer Periodenlänge im Bereich der Wellenlänge des von der OLED emittierten Lichts zwischen Substrat und erster Elektrode zu erzeugen, wobei sich diese periodische Struktur in die optisch aktive Schicht der lichtemittierenden Diode fortsetzt. Die angegebene Geometrie hat letztlich eine Bragg-Streuung zur Folge, welche die Effizienz des Bauelementes erhöht, siehe J.M. Lupton et al, Appl. Phys. Lett., Bd. 77, Seite 3340 (2000). Die deutsche Offenlegungsschrift DE 101 64 016 A1 betrifft darüber hinaus eine organische Leuchtdiode, bei welcher die zumindest eine organische Schicht verschiedene Teilbereiche mit unterschiedlichen Brechungsindizes aufweist. Aufgrund der Umlenkung an den Phasengrenzen innerhalb der Organik bleiben weniger Photonen durch Wellenleitverluste in der Schicht gefangen als bei homogenen Schichten.

Neben dieser Ausnutzung von intrinsischen Inhomogenitäten in der aktiven organischen Schicht ist darüber hinaus bekannt, Fremdkörper wie Nanopartikel in das organische elektrolumineszierende Material einzubringen, sodass Wellenleitereffekte innerhalb der Organik vermieden werden können, siehe beispielsweise "Enhanced luminance in polymer composite light emitting devices", von S.A. Carter et al, Appl. Phys. Lett., Bd. 71 (1997). Diese Nanopartikel können beispielsweise aus TiO₂, SiO₂ oder Al₂O₃ bestehen und in ein polymeres Emittermaterial, wie MEH-PPV eingebettet sein.

In dem Dokument US 2003/0127973 A1 wird vorgeschlagen, in OLEDs eine Polymerschicht mit darin enthaltenen Mikropartikeln zu versehen. Als Größe der Mikropartikeln wird ein Bereich von 0,4 µm bis 10 µm vorgeschlagen.

Neben den bottom-emittierenden OLEDs gewinnen die top-emittierenden OLEDs zunehmend an Relevanz, da sie für spezifische Anwendungen gegenüber den erstgenannten Vorteile aufweisen. Sind sowohl beide Elektroden als auch das Substrat transparent, kann ein in seiner Gesamtheit, d.h. ein nach oben und unten abstrahlendes elektrolumineszierendes Bauelement bereitgestellt werden. Wenn das Substrat wie beim top-emittierenden OLED nicht transparent sein muss, können neben Glas auch viele andere Substrate verwendet werden, die es beispielsweise ermöglichen, dass das Bauelement flexibel, d.h. biegsam ist. Darüber hinaus können bei einem derartigen top-emittierenden elektrolumineszierenden Bauelement auch Metallfolien, Silizium-Wafer oder andere Substrate mit Silizium basierenden elektronischen Bauelementen sowie Leiterplatten als Substrate dienen.

Der Erfindung liegt die Aufgabe zugrunde, bei einem gattungsgemäßen, top-emittierenden, elektrolumineszierenden Bauelement die Auskoppeleffizienz des innerhalb der zumindest einen organischen Schicht erzeugten Lichtes zu verbessern. Diese Aufgabe wird auf überraschende einfache Weise vorrichtungsseitig schon mit einem Bauelement mit den Merkmalen von Anspruch 1 gelöst. Dabei umfasst das erfindungsgemäße top-emittierende elektrolumineszierende Bauelement, welches insbesondere als organische Leuchtdiodeneinrichtung ausgebildet ist, ein Substrat, eine zum Substrat nächstliegende erste Elektrode, eine zum Substrat entfernt gelegene zweite Elektrode und zumindest eine zwischen beiden Elektroden angeordnete lichtemittierende organische Schicht, wobei emittiertes Licht durch die zweite Elektrode hindurch transmittiert. Das Bauelement zeichnet sich gemäß der Erfindung dadurch aus, dass auf der Seite der zweiten Elektrode, welche der zumindest einen organischen Schicht abgewandt ist, eine Zusatzschicht angeordnet ist, welche optisch wirksame, lichtstreuende Heterogenitäten, insbesondere in Form von Streuzentren aufweist, wobei der Transmissionsgrad der Zusatzschicht des emittierten Lichtes größer 0,6 beträgt. Dabei bestimmt sich der Transmissionsgrad τ der Zusatzschicht nach der einschlägigen Formel τ = e^{-(αd)}, wobei α den Absorptionskoeffizienten und d die Dicke der Schicht angibt

Durch die erfindungsgemäße Gestaltung des top-emittierenden, elektrolumineszierenden Bauelementes kann dessen Auskoppeleffizienz je nach spezifischer Ausführungsform bis um den Faktor 4 erhöht werden, was eine wesentliche Verbesserung darstellt. Darüber hinaus kann die Zusatzschicht neben der angegebenen Funktion auch noch weitere Funktionen übernehmen.

Der Erfindung liegt die Idee zugrunde, mit dem Vorsehen einer Auskoppelschicht auf der Seite der zweiten Elektrode, welche der beziehungsweise den organischen Schichten abgewandt ist, die Ausbreitung der optischen Moden innerhalb der organischen Schichten und der transparenten Elektrode so zu beeinflussen, dass die Auskoppeleffizienz erhöht wird. Hierzu eignen sich optisch wirksame Heterogenitäten, welche auf beliebige Art eine Ablenkung des Lichtes verursachen. Diese können beispielsweise Streu- oder auch Beugungseffekte hervorrufen, wobei die wirksamen Zentren sowohl innerhalb der Auskoppelschicht als auch an deren Grenzflächen, insbesondere an der Grenzfläche, welche von der Elektrode abgewandt ist, angeordnet sein können. Darüber hinaus können die Heterogenitäten sowohl extrinsischer Natur als auch intrinsisch durch die Schicht selbst verursacht sein. Durch die besondere Gestaltung der Auskoppelschicht wird ververhindert, dass sich optische Moden in der beziehungsweise den organischen Schichten und/oder in der Kontaktschicht ausbilden kann, sodass das Licht überwiegend in externe Moden einkoppelt. Die Auskoppelschicht muss dabei transparent sein um zu vermeiden, dass zu viel Licht innerhalb der Zusatzschicht absorbiert wird. Die Erfinder haben herausgefunden, dass ein Transmissionsgrad von größer 0,6 ausreicht, um letztlich mehr Licht aus dem erfindungsgemäßen Bauelement herauszukoppeln.

Weil die Zusatzschicht und die zweite Elektrode eine gemeinsame Grenzfläche bilden und miteinander verbunden sind, ergibt sich eine besonders wirksame Einkopplung der Organik-Moden in die Zusatzschicht.

Vorteilhafte Ausführungsformen sind in den Unteransprüchen angegeben.

Ein besonders hoher Wirkungsgrad für die Auskopplung kann bereitgestellt werden, wenn die optisch wirksamen Heterogenitäten innerhalb der Schicht, insbesondere homogen innerhalb dem Volumen der Zusatzschicht als Streupartikel angeordnet sind, wobei diese eine Größe von etwa 0,05 µm bis 100 µm aufweisen. Die angegebene Größe der Streupartikel stellt sicher, dass keine wellenlängenabhängige Streuung in Form von Rayleigh-Streuung auftritt, deren Intensität proportional zu 1/λ⁴ ist. Sind die Streupartikel größer als etwa 100 µm, erfolgt die Streuung weitgehendst in Vorwärtsrichtung mit erhöhter Absorption, was ebenso wie die wellenlängenabhängige Streuung unerwünscht ist. Erfindungsgemäß umfasst der Begriff "Streupartikel" jede Partikel oder Bereiche in der Zusatzschicht mit der angegebenen Ausdehnung zwischen 0,05 µm und 100 µm, die im Wesentlichen Miestreuende, d.h. wellenlängenunabhängige Eigenschaften besitzen.

Darüber hinaus kann es jedoch auch zweckmäßig sein, wenn die optisch wirksamen Heterogenitäten an der Oberfläche der Zusatzschicht angeordnet sind, welche der zweiten Elektrode abgewandt ist, wobei die Streuzentren eine Größe von etwa 0,05 µm bis 100 µm aufweisen.

Eine besonders wirksame Auskoppelschicht kann dadurch bereitgestellt werden, dass sowohl innerhalb der Zusatzschicht als auch an deren Oberfläche die angegebenen Heterogenitäten angeordnet sind.

Zweckmäßigerweise kann die Dicke der zweiten Elektrode kleiner als 200 nm sein, insbesondere weniger als 80 nm betragen, wodurch sich eine besonders effektive Einkopplung des Lichtes aus der Organik in die Zusatzschicht ergibt, da das evaneszente Feld durch die zweite Elektrode nicht stark abgeschwächt wird. Vorteilhaft kann dabei der Brechungsindex der Zusatzschicht größer als der Brechungsindex der nächstgelegenen, zwischen den Elektroden angeordneten organischen Schicht eingerichtet sein. Besonders vorteilhaft ist es, wenn die Dicke der zweiten Elektrode noch geringer ist, insbesondere etwa 40 nm beträgt.

Um eine Totalreflexion des Lichtes an der Grenzfläche zwischen der zweiten Elektrode und der Zusatzschicht zu vermeiden, wenn das Licht von der Elektrode in die Zusatzschicht eintritt, kann vorgesehen sein, dass der Brechungsindex der Zusatzschicht größer als der Brechungsindex der zweiten Elektrode ist. Dabei kann es zweckmäßig sein, wenn der Brechungsindex der Zusatzschicht, zwischen 1,3 und 2,3, insbesondere zwischen 1,6 und 2,0 liegt. Dadurch werden die Organik-Moden vollständig oder zu einem wesentlichen Teil in die Auskoppelschicht eingekoppelt. Grundsätzlich kann festgestellt werden, dass auch top-emittierende, elektrolumineszierende Bauelemente mit der erfindungsgemäßen Auskoppelschicht ausgestattet sein können, wenn diese mehrere organische Schichten aufweist. Wie insbesondere in der deutschen Offenlegungsschrift DE 102 15 210 A1 angegeben, kann es vorteilhaft sein, wenn neben der lichtemittierenden organischen Schicht zwischen den beiden Elektroden auch noch andere organische Schichten angeordnet sind. Eine solche allgemeine Struktur eines Bauelements weist im Fall eines nichtinvertierten Aufbaus die folgenden Schichten auf:
1. Substrat,
2. erste Elektrode, löcherinjizierende Anode,
3. p-dodierte, löcherinjizierende und transportierende Schicht,
4. dünne, löcherseitige Zwischenschicht aus einem Material, dessen Energieniveau des HOMOs (highest occupied molecule orbital) zu den Energieniveaus der HOMOs der sie umgebenden Schichten passt,
5. lichtemittierende Schicht,
6. dünne elektronenseitige Zwischenschicht aus einem Material, dessen Energieniveau des LUMOs (lowest unoccupied molecule orbital) zu den Energieniveaus der LUMOs der sie umgebenden Schichten passt,
7. n-dotierte Elektronen injizierende und transportierende Schicht,
8. zweite Elektrode, elektroinjizierende Kathode.

Im Falle eines invertierenden Aufbaus des Bauelements ergeben sich folgende Schichten:
1. Substrat,
2. a) erste Elektrode, elektroneninjizierende Kathode,
3. a) n-dotierte, elektroneninjizierende und transportierende Schicht,
4. a) dünne elektronenseitige Zwischenschicht aus einem Material, dessen Energieniveau des LUMOs (lowest unoccupied molecule orbital) zu den Energieniveaus der LUMOs der sie umgebenden Schichten passt,
5. a) lichtemittierende Schicht,
6. a) dünne, löcherseitige Zwischenschicht aus einem Material, dessen Energieniveau des HOMOs (highest occupied molecule orbital) zu den Energieniveaus der HOMOs der sie umgebenden Schichten passt,
7. a) p-dotierte löcherinjizierende und transportierende Schicht,
8. a) zweite Elektrode, löcherinjizierende Anode.

Wie in der Offenlegungsschrift DE 102 15 210 A1 angegeben, kann die Löchertransportschicht mit einem akzeptorartigen organischen Material p-dotiert und die Elektronentransportschicht mit einem donatorartigen organischen Material n-dotiert sein. Diese Dotierung hat eine erhöhte Leitfähigkeit zur Folge, sodass die Transportschichten höhere Schichtdicken als üblich aufweisen können im Vergleich zu undotierten Schichten (typischerweise 20 bis 40 nm), ohne dass die Betriebsspannung drastisch erhöht wird. Insofern kann es im Falle eines nichtinvertierten Aufbaus des erfindungsgemäßen Bauelementes zweckmäßig sein, wenn zwischen der Zusatzschicht und der aktiven organischen Schicht eine weitere organische Schicht angeordnet ist, die eine Elektronentransportschicht ist, die mit einem donatorartigen organischen Material n-dotiert ist und eine Dicke zwischen 50 nm und 2 µm, insbesondere eine Dicke zwischen 100 nm und 1000 nm aufweist. Im Falle eines invertierenden Aufbaus des Bauelementes ist diese weitere organische Schicht eine Löchertransportschicht, die mit einem akzeptorartigen organischen Material p-dotiert ist und eine Dicke zwischen 50 nm und 2 µm, insbesondere eine Dicke zwischen 100 nm und 1000 nm aufweist. Es versteht sich, dass gemäß der obenstehend angegebenen allgemeinen Struktur eines erfindungsgemäßen Bauelementes zwischen der Zusatzschicht und der aktiven organischen Schicht darüber hinaus noch eine Elektrode sowie unter Umständen eine Blockschicht angeordnet ist.

Der Vollständigkeit halber sei darauf hingewiesen, dass je nach Ausführungsform des erfindungsgemäßen Bauelementes bei invertierender beziehungsweise nichtinvertierender Bauart nicht alle obenstehend angegebenen Schichtarten umfasst sein müssen, darüber hinaus können jedoch auch noch andere Schichten wie beispielsweise eine dünne (kleiner 10 nm) kontaktverbessernde Schicht zwischen der Elektronentransportschicht und der Kathode und/oder zwischen der Anode und der Löchertransportschicht vorgesehen sein. Wesentlich für die nachfolgenden Prozessschritte, insbesondere für das Aufbringen der Auskoppelschicht angrenzend zur zweiten Elektrode beziehungsweise benachbart zu dieser ist, dass eine dicke dotierte Ladungstransportschicht zwischen der lichtemittierenden organischen Schicht und der Auskoppelschicht vorliegt, welche einen Schutz für die lichtemittierende Schicht bei der Herstellung der Auskoppelschicht darstellt.

Zweckmäßigerweise weist die Zusatzschicht als Auskoppelschicht eine Dicke zwischen 0,05 µm und 1000 µm, insbesondere zwischen 0,5 µm und 100 µm auf.

Es kann zweckmäßig sein, wenn die Zusatzschicht derartig gestaltet ist, dass sie nicht nur die Auskoppeleffizienz des Lichtes erhöht, sondern gleichzeitig auch einen Schutz für die zwischen den Elektroden angeordneten Schichten gegen mechanische Belastung, elektromagnetische Strahlungen, Teilchenstrahlungen, Feuchtigkeit, Luft und/oder chemische Einflüsse darstellt. Die Zusatzschicht bietet auf diese Weise zusätzlich eine Kapselung oder Schutzfunktion, welche insbesondere bei Displayanwendungen vorteilhaft ist.

Das Aufbringen der Zusatzschicht kann über eine oder mehrere von bekannten Techniken auf die zweite Elektrode erfolgen. Beispielsweise kann die Zusatzschicht aufgesputtert sein, kristallin aufgewachsen oder auch amorph abgeschieden sein. Einzige Voraussetzung ist, dass die Zusatzschicht die obenstehend angegebenen optischen Heterogenitäten zur Erhöhung der Auskoppeleffizienz aufweist.

Verfahrensseitig löst die Erfindung die obige Aufgabe mit einem Verfahren zur Herstellung eines top-emittierenden, elektrolumineszierenden Bauelementes nach Anspruch 11.

Die Zusatzschicht wird aus der Gasphase aufgedampft, wobei die Dampfparameter derart eingestellt werden, dass der Ausbildung von polykristallinen Mikrostrukturen und Versetzungen bevorzugt werden, welche im Betrieb als optische Heterogenitäten zur Steigerung der Auskoppeleffizienz des Bauelementes wirken.

Um eine besonders hohe Dichte der optisch wirksamen Heterogenitäten zu erzeugen kann vorgesehen sein, dass bei der Herstellung der Zusatzschicht unterschiedliche Materialien mit unterschiedlichen Gitterkonstanten aufgedampft werden. Hierdurch wird das Auftreten von polykristallinem Wachstum und/oder Versetzungsgrenzen in der Zusatzschicht verstärkt. Dabei können die unterschiedlichen Materialien entweder gleichzeitig aufgedampft werden oder nacheinander, sodass die Zusatzschicht aus einer Abfolge von dünnen Schichten verschiedener Materialien besteht.

Wie obenstehend schon erläutert, kann vorteilhaft eine zwischen 100 nm und 1000 nm dicke, eine organische Dotierung aufweisende Transportschicht aufgebracht werden, sodass die Zusatzschicht nachfolgend auf die obere dünne Kontaktschicht (transparente Elektrode) nasschemisch, durch thermisches Aufdampfen oder durch Sputtern aufgebracht werden kann, ohne dass die lichtemittierende organische Schicht geschädigt wird. Dabei kann es auch zweckmäßig sein, wenn die Zusatzschicht unter Verwendung eines inerten Gases aufgesputtert wird, damit die organischen Schichten des Bauelementes nicht durch eine Reaktion mit dem Plasma beschädigt werden.

Bei der Herstellung kann es zweckmäßig sein, wenn zur Bildung der Zusatzschicht das Material der Zusatzschicht und das die Streuzentren bildende Material abwechselnd aufgesputtert oder aufgedampft wird. Demnach kann für das jeweilige Material die optimale Aufbringtechnik verwendet werden. Insofern können beide Materialien mit der gleichen Technik oder mit unterschiedlichen Techniken aufgebracht werden.

Wie auch schon erläutert, können die optischen Heterogenitäten zweckmäßigerweise auch an der Oberfläche der Zusatzschicht erzeugt werden, welche der zweiten Elektrode abgewandt ist. Hierzu eignen sich beispielsweise die Verfahren Bürsten, Schleifen, Sandstrahlen oder auch Mikrostrukturieren der Zusatzschicht durch photolithographische Techniken. Bei diesen mechanischen Verfahren sind die Prozessparameter so zu wählen, dass die organische Leuchtdiode nicht geschädigt wird. Zweckmäßigerweise sollte die Auskoppelschicht hierzu eine ausreichende mechanische Stabilität besitzen. Unter Umständen kann es hierbei zweckmäßig sein, Bi- oder Multi-Layer für die Zusatzschicht zu verwenden, um diesen Anforderungen gerecht zu werden. Die angegebenen Verfahren wie Sandstrahlen, Schleifen und Bürsten sind Verfahren, mit deren Hilfe von der Oberfläche der Auskoppelschicht ungleichmäßig Material abgetragen wird, wodurch eine aufgeraute Oberfläche entsteht, welche in beschriebener Weise zur verbesserten Auskopplung des Lichtes beiträgt.

Ein Verfahren stellt das Aufbringen einer Oberflächenstruktur durch Drücken eines mikrostrukturierten Stempels in die äußere Oberfläche der Zusatzschicht dar. Durch das Aufbringen des Stempeldrucks wird entweder das Material der Auskoppelschicht dauerhaft verformt oder partiell gespaltet, wodurch eine ungleichmäßig geformte Oberfläche entsteht, welche den gewünschten Effekt zur Erhöhung der Lichtauskopplung hervorruft.

Um zu vermeiden, dass die unter der Auskoppelschicht liegende OLED beim Aufbringen des Stempeldrucks beschädigt wird, kann vorgesehen sein, dass die durch den Prägevorgang in die Zusatzschicht eingebrachten Kräfte im wesentlichen längs der Schicht verlaufen. Dies kann insbesondere durch eine entsprechende geometrische Gestaltung des Stempels erreicht werden.

Es kann jedoch auch zweckmäßig sein, wenn der Stempel zur Strukturierung einer Oberfläche der Zusatzschicht eine Wellenform aufweist, wobei der Stempel z.B. mittels eines Photolithographieverfahrens herstellbar ist.

Darüber hinaus kann vorteilhaft auch ein photolithographisches Verfahren oder ein Siebdruckverfahren zur Erzeugung einer strukturierten Oberfläche an der Zusatzschicht verwendet werden.

Ein besonders für die OLED schonendes Verfahren zum Aufbringen der Zusatzschicht besteht darin, diese zuerst als Film herzustellen und nachfolgend auf das Bauteil aufzulaminieren oder aufzukleben.

Die Erfindung wird durch das Beschreiben einer Vielzahl von Ausführungsformen unter Bezugnahme auf die beiliegenden Figuren erläutert, wobei
- Fig. 1: eine herkömmliche top-emittierende OLED in einer Prinzipdarstellung,
- Fig. 2: ein top-emittierendes Bauelement in einer Prinzipdarstellung,
- Fig. 3 a/b): ein top-emittierendes Bauelement in einer Prinzipdarstellung,
- Fig. 4: ein Verfahren zur Herstellung eines top-emittierenden Bauelementes in einer Prinzipdarstellung,
- Fig. 5: das in Fig. 4 dargestellte prinzipielle Verfahren an einer realen OLED-Struktur und
- Fig. 6: das in Fig. 4 dargestellte prinzipielle Verfahren an einer anderen OLED-Struktur
zeigt.

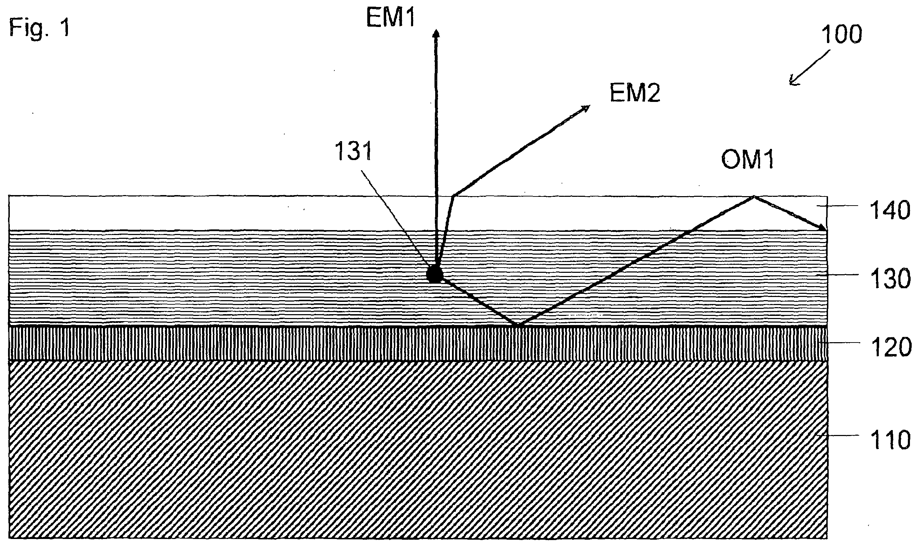

Fig. 1 zeigt in einer Prinzipskizze den Aufbau eines herkömmlichen top-emittierenden Bauelementes 100. Im angegebenen Beispiel ist die dem Substrat 110 nächstgelegene Elektrode 120, die im Folgenden als erste Elektrode bezeichnet wird, als reflektierende Metallschicht ausgeführt. Auf die erste Elektrode sind mehrere organische Schichten aufgebracht, welche in der Figur als organische Schichtstruktur 130 angegeben ist. Diese Schichtstruktur umfasst zumindest eine organische elektrolumineszierende Schicht. An die Schichtstruktur 130 schließt sich eine zweite Elektrode 140 an, die aus einem transparenten Material, beispielsweise einem leitfähigen Oxid besteht.

Bei Anlegung einer Spannung zwischen den beiden Elektroden werden Ladungsträger, d.h. Elektronen von der einen und Löcher von der anderen Seite aus den Kontakten in die dazwischen befindlichen organischen Schichten injiziert, worauf sich Elektron-Loch-Paare in der aktiven Zone bilden, welche unter Lichtabgabe rekombinieren. In der Figur ist eine beispielhafter Emissionspunkt mit der Ziffer 131 bezeichnet. Ausgehend von diesem Emissionsort propagiert das Licht, wobei in der Figur dies mit einzelnen Pfeilen angedeutet ist. Wie zu erkennen, erfolgt an den Grenzflächen zwischen zwei Schichten eine Reflexion des Lichtes und/oder eine Transmission in die nächste Schicht hinein. Das Licht, welches innerhalb des Bauelementes, hier innerhalb der Schichtstruktur 130 und/oder der Elektrode 140 verbleibt (Strahl OM1) wird als Organik-Mode bezeichnet, das Licht, welches das Bauelement verlässt (Strahlen EM1, EM2) wird als externe Moden bezeichnet. Da auch die organischen Schichten einen Absorptionskoeffizienten ungleich 0 für das innerhalb der Schichten erzeugte Licht besitzen, wird dieses im Laufe der Propagation in Längsrichtung zur Schicht absorbiert.

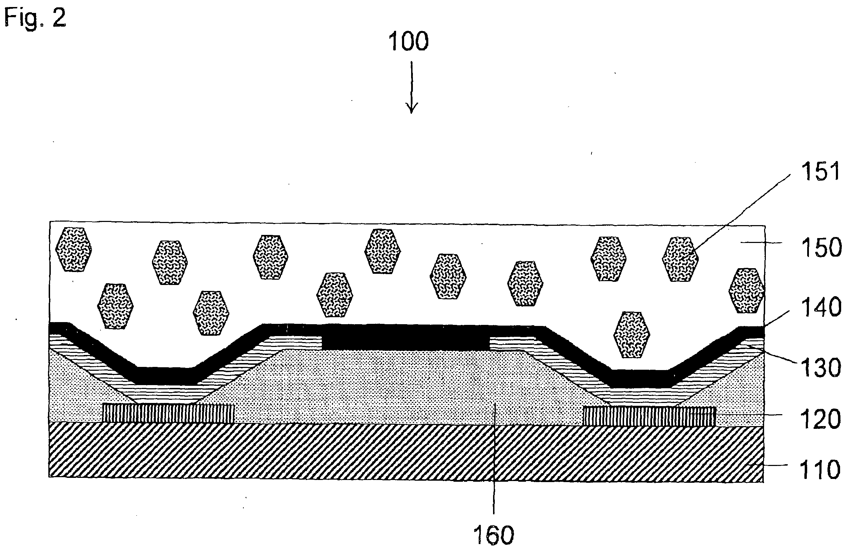

Hier setzt nun die Erfindung mit einer solchen Gestaltung der OLED an, dass bei einem top-emittierenden Bauelement die Auskoppeleffizienz erhöht wird. Hierzu ist erfindungsgemäß eine auch als Auskoppelschicht bezeichnete Zusatzschicht auf der Seite der zweiten Elektrode vorgesehen, welche optisch wirksame Heterogenitäten wie Streuzentren aufweist, wobei diese Heterogenitäten innerhalb der Auskoppelschicht angeordnet sind. Eine erste Ausführungsform hierfür ist in Fig. 2 in einer Prinzipskizze dargestellt. Da die Anzahl der organischen Schichten für die vorliegende Erfindung eine untergeordnete Rolle spielt, sind diese in Fig. 2 auch nur als Schichtstruktur 130 angegeben. Auf das als Rückplatine (backplane) ausgebildete Substrat 110 ist wiederum eine dieser zugeordnete Elektrode 120 aufgebracht, an die sich die organische Schichtstruktur 130 anschließt, in welcher das Licht, in der Regel im sichtbaren Bereich, erzeugt wird. Daran schließt sich herkömmlicherweise die zweite Elektrode 140 an, auf die erfindungsgemäß eine zusätzliche Schicht, die Auskoppelschicht 150, aufgebracht ist.

Das in Fig. 2 dargestellte erfindungsgemäße Bauelement kann je nach Ausführungsform auf verschiedene Weisen erzeugt werden. Die dabei erzeugte Auskoppelschicht zeigt ohne weitere Zusätze schon allein durch intrinsische Heterogenitäten innerhalb der Schicht in der angegebenen Größenordnung streuende Eigenschaften.

Eine weitere Klasse von erfindungsgemäßen top-emittierenden elektrolumineszierenden Bauelementen wird dadurch hergestellt, dass die Zusatzschicht durch eines der Verfahren Sputtern, PVD

(physical vapor deposition), CVD (chemical vapor depostion), PECVD (plasma enhanced chemical vapor deposition), MBE (molecular beam epitaxy), MEE (molecular enhanced epitaxy), MOVPE (metal organic vapor pressure epitaxy) oder OVPD (organic vapor phase deposition) aufgebracht wird. Bei der Verwendung dieser auch nur beispielhaft aufgeführten Verfahren werden die folgenden Materialien verwendet:
- Binäre Halbleiterverbindungen mit großer Bandlücke wie z.B. II-VI und Gruppe III-Nitrid-Verbindungen sowie deren Verbindungshalbleiter.

Die meisten dieser für die Zusatzschicht aufgeführten Materialien zeichnen sich neben ihrer Transparenz im sichtbaren Spektralbereich durch einen Brechungsindex aus, der größer oder gleich dem der organischen Schichten ist. Insofern wird das in der aktiven organischen Schicht erzeugte Licht besonders effektiv aus den organischen Schichten in die Zusatzschicht des erfindungsgemäßen Bauelementes eingekoppelt und von dort durch die angegebenen Streuzentren aus der Struktur ausgekoppelt. Da die meisten dieser Materialien der Zusatzschicht zwar im sichtbaren Spektralbereich transparent sind, aber im UV-Bereich hoch absorbieren, bieten derartige Zusatzschichten den organischen Schichten nicht nur Schutz gegen Feuchtigkeit und Luft, sondern auch gegen UV-Strahlung.

Insbesondere beim Sputtern von Metalloxiden, beispielsweise zum Aufbringen der transparenten Elektrode in Form von ITO können die organischen Schichten des Bauelementes entweder durch Reaktion mit dem Plasma oder auch mechanisch beschädigt werden. Aus diesem Grund ist die oberste organische Schicht der Diode zum Schutz der lichtemittierenden Schicht in der Regel besonders dick ausgebildet. Um zu vermeiden, dass der Spannungsabfall über dieser obersten organischen Schicht der Diode zu hoch ist, kann gemäß der Offenlegungsschrift DE 102 15 210 A1, deren Offenbarungsgehalt vollständig durch Bezugnahme hier eingebunden wird, die Leitfähigkeit dieser Schicht durch Dotierung erhöht werden. Je nach Ausführungsform weist beispielsweise die Transportschicht eine Dicke zwischen 100 nm und 1 µm auf, sodass die aktive organische Schicht unterhalb der Transportschicht bei den nachfolgenden Prozessschritten insbesondere dem Aufsputtern der transparenten Elektrode und/oder dem Aufsputtern der Zusatzschicht geschützt ist.

Das Material der Zusatzschicht, wie beispielsweise ZnSe oder GaN, wird aus der Gasphase abgeschieden, wodurch die organischen Schichten der Diode weit weniger belastet werden, da bei diesem Herstellungsverfahren kein Gasplasma benötigt wird. Das jeweilige Material der Zusatzschicht wird durch thermisches Verdampfen im Vakuum auf die transparente Elektrode aufgebracht. Typische Verdampfungstemperaturen liegen beispielsweise für ZnSe bei 600°C bis 800°C. Bei dem Aufdampfprozess befindet sich das Bauelement in ausreichender Entfernung zur Heizquelle, sodass für die organischen Schichten der Schichtstruktur keine Gefahr durch Wärmestrahlung besteht. Wiederum kann der Einfluss von Wärme auf die OLED durch dicke, dotierte Transportschichten minimiert werden.

Der Einbau der Streuzentren in die Schicht geschieht beim Aufdampfen aus der Gasphase aufgrund der vorherrschenden Wachstumsbedingungen für die Zusatzschicht automatisch. Da die Bauelementoberfläche nicht ausreichend glatt ist und eine Temperatur von RT aufweist, kann kein einkristalliner glatter Film aufwachsen, aus thermodynamischen Gründen kommt es jedoch auch nicht zu einem völlig amorphen Schichtwachstum. Die Wachstumsbedingungen führen zu einer Ausklumpung von polykristallinen Mikrostrukturen an entstandenen Wachstumskeimen, die über die Zeit zu einer geschlossenen Schicht zusammenwachsen. Hierdurch entstehen Versetzungsgrenzen der einzelnen mikrokristallinen Bereiche, wodurch die gewünschten optischen Heterogenitäten in Form von Streuzentren gebildet sind. Diese Versetzungsgrenzen sind besonders in Wachstumsrichtung ausgeprägt und führen zu der gewünschten Streuung des in die Zusatzschicht eingekoppelten Lichtes. Die Separation der Zusatz- oder Auskoppelschicht in einzelne mikrokristalline Domänen kann noch weiter verstärkt werden, in dem abwechselnd unterschiedliche II-VI-Materialien wie beispielsweise ZnSe und CdS oder Gruppe III-Nitride wie GaN und AlN aufgedampft werden. Diese klumpen aufgrund ihrer unterschiedlichen Gitterstruktur bevorzugt in separaten Kristalldomänen aus und weisen zusätzlich unterschiedliche Brechungsindizes auf, sodass hierdurch besonders wirksame optische Heterogenitäten gebildet sind.

Bei den nicht beanspruchten Ausführungsformen, bei welchen die Auskoppelschicht durch Sputtern von Metalloxiden gebildet ist, entsteht ein vollständig amorpher Film. In einer nicht beanspruchten Ausführungsform werden die Streupartikel in die Zusatzschicht durch abwechselndes Sputtern des Materials der Zusatzschicht und dem Aufbringen von Mikro-Metallpartikeln mit Hilfe von Kaltsprayverfahren erreicht. In einem solchen Kaltsprayverfahren wird ein Metallpuder, beispielsweise Kupferpuder, als mikrometergroße Streuzentren in die Auskoppelschicht eingebracht. In einer anderen nicht beanspruchten Ausführungsform wird die Zusatzschicht mit darin enthaltenen optischen Heterogenitäten dadurch erzeugt, dass das Zusatzschichtmaterial und ein Metall wie beispielsweise Kupfer abwechselnd auf das Bauelement gesputtert wird. Hierbei wird das Metall nur sehr kurz gesputtert, damit lediglich Metall-Cluster entstehen, jedoch kein durchgängiger Metallfilm, der zu stark absorbieren würde.

Bei nicht beanspruchten Ausführungsformen, bei welchen organische Schichten zur Gestaltung der Auskoppelschicht aufgedampft werden, besteht auch die Möglichkeit des Einbringens der Streuzentren durch das Sputtern oder Kaltsprayverfahren, sodass Mikro-Metallpartikel oder Metalloxid-Cluster als Heterogenitäten in der Zusatzschicht vorliegen. In einer anderen nicht beanspruchten Ausführungsform werden Cluster von Halbleiterverbindungen zwischen die organischen Schichten aufgedampft. Bei einer noch anderen nicht beanspruchten Ausführungsform des Bauelementes werden zur Erzeugung der Streuzentren in der Auskoppelschicht organische Materialien gewählt, die selbst polykristallin auskristallisieren. Je nach Ausführungsform wird bei einem solchen Bauelement die Zusatzschicht beispielsweise gebildet durch Antracen, Phthalocyanine, Terphenyldiamine (TPD), Perylene-Tetracarboxylic-Dianhydride (PTCDA) oder BPhen.

Darüber hinaus existieren auch nicht beanspruchte Ausführungsformen, bei welchen die Zusatzschicht durch Aufdampfen organischer Schichten und nachfolgender Polymerisation, beispielsweise durch UV-Bestrahlung erzeugt wird. Zusätzliche Streuzentren in Form von Mikro-Metallpartikeln oder Metalloxid-Clustern können wiederum über ein Kaltsprayverfahren oder ein Metallsputtern in die Auskoppelschicht eingebracht werden. Beispielhaft sei eine Zusatzschicht aus Methylmethacrylat (MMA) angegeben, welches nach dem Einbringen der Streupartikel durch Bestrahlung mit UV-Licht zu Plexiglas (PMMA) polymerisiert wird. Diese nachträgliche Polymerisation der Schicht weist den Vorteil auf, dass die Zusatzschicht nicht durch das Einbringen der Streupartikel beschädigt wird.

Die bisher beschriebenen Ausführungsformen des Bauelementes beschränken sich auf OLEDs mit einer zusätzlichen Auskoppelschicht an der zweiten Elektrode, wobei optische Heterogenitäten innerhalb der Zusatzschicht angeordnet sind.

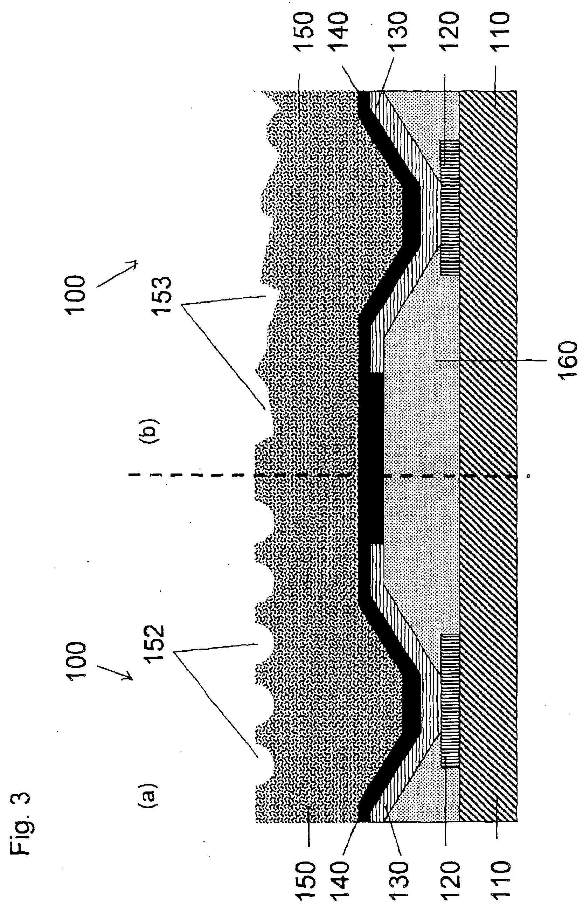

Fig. 3 a/b) zeigt Ausführungsformen eines nicht erfindungsgemäßen top-emittierenden, elektrolumineszierenden Bauelementes mit einer Auskoppelschicht, deren zur zweiten Elektrode abgewandte Oberfläche strukturiert ist. Die Gestaltung des Substrates 110, der ersten Elektrode 120, der organischen Schichtstruktur 130 und der zweiten Elektrode 140 ist identisch mit dem in Fig. 2 gezeigten Beispiel. Die Strukturierung der Oberfläche wird im Falle der in Fig. 3a in einer Seitenansicht gezeigten Ausführungsform durch eine gleichförmige Aneinanderreihung von symmetrischen Furchen oder Rillen 152 an der Oberfläche der Auskoppelschicht 150 bereitgestellt. Diese Strukturierung ist in der in Fig. 3a dargestellten Ausführungsform durch Bürsten der Zusatzschicht in einer Richtung senkrecht zur Zeichnungsebene erzeugt worden. In einer nicht dargestellten Ausführungsform kann die Strukturierung der Oberfläche auch in Form von Kuhlen oder Vertiefungen ausgeführt sein, wobei die Strukturierungen sowohl eindimensional, d.h. linienförmig als auch zweidimensional gestaltet sein können.

Dagegen weist die in Fig. 3b gezeigte nicht beanspruchte Ausführungsform eine Strukturierung der Oberfläche der Zusatzschicht 150 auf, die nicht gleichförmig ist, sondern zufällig verteilte und geformte Ausbrüche oder Ausnehmungen 153 umfasst, die mittels eines Schleifverfahrens erzeugt wurden.

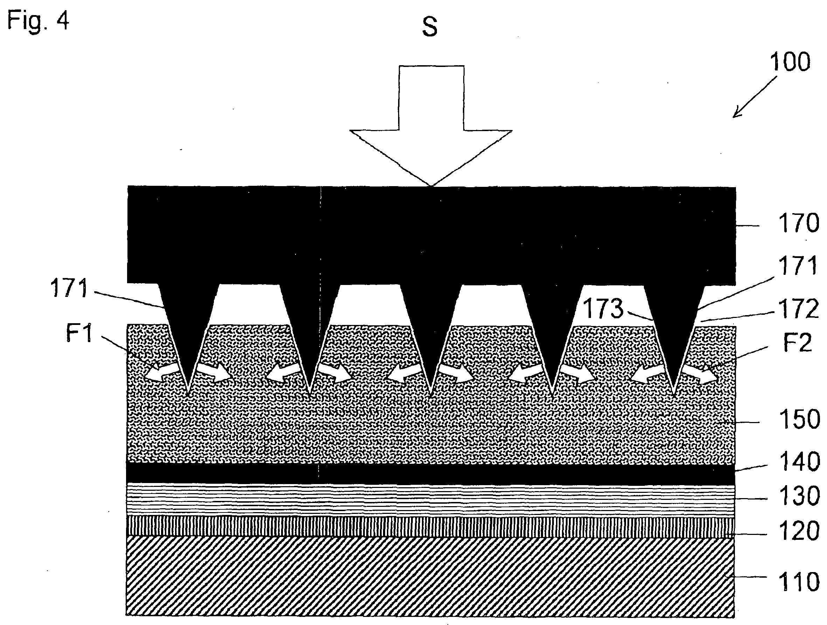

Fig. 4 zeigt in einer Prinzipskizze die nicht beanspruchte Strukturierung der Zusatzschicht 150 mittels eines Stempels 170, welcher eine Vielzahl von gleich beabstandeten Schneiden 171 aufweist, die durch zwei spitz zulaufende Flächen 172, 173 gebildet sind. In einem ersten Verfahrensschritt wird die Zusatzschicht 150 auf die zweite Elektrode 140 aufgebracht und nachfolgend mit dem in der Figur 4 dargestellten Prozessschritt an ihrer Oberfläche strukturiert. Hierzu wird der beschriebene Stempel 170 auf die Oberfläche der Zusatzschicht 150 aufgesetzt und mit einer vorgegebenen Stempelkraft S in diese eingedrückt. Durch die angegebene Gestaltung der Schneiden 171 entsteht in der Zusatzschicht 150 ein Kräfteverlauf wie er durch die Pfeile F1, F2 angegeben ist. Wie aus der Figur ersichtlich, wird durch die angegebene Gestaltung des Stempels ein Großteil der aufgewendeten Stempelkraft seitlich innerhalb der Auskoppelschicht 150 abgefühlt, sodass die darunter liegenden organischen Schichten 130 nicht belastet werden. Nach dem Entfernen des Stempels ist die Oberfläche der Auskoppelschicht 150 durch eine Vielzahl von gleich beabstandeten Rillen strukturiert, da die Spaltung der Zusatzschicht an deren Oberfläche irreversibel ist. Diese Rillen bzw. deren Begrenzungsflächen bilden dem gemäß die optisch aktiven Heterogenitäten.

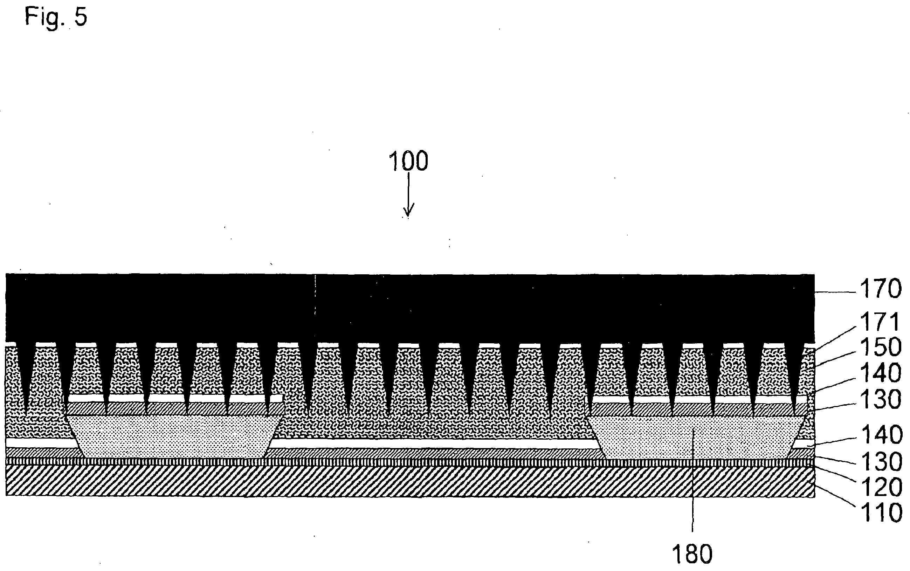

In einer weiteren, in Fig. 5 gezeigten nicht beanspruchten Ausführungsform der Erfindung sind im Bauteil zusätzliche Separatoren 180 (beispielsweise aus Photolack oder aus SiO₂) integriert, die verhindern, dass der als Formwerkzeug dienende Stempel 170 bis in die organische Schichtstruktur hinein Verformungen oder Schädigungen bewirkt. Insbesondere in Aktiv- bzw. Passiv-Matrixdisplays sind derartige Strukturen zur Kathodenseparation oder Pixeldefinition ohnehin vorgesehen. Diese in den Displays vorhandenen Separatoren 180 sind für die Nutzung in der vorliegenden Erfindung nur dahingehend ausgelegt, dass sie im Hinblick auf Abmessung und Stabilität dem Formvorgang mit dem Formwerkzeug 170 standhalten.

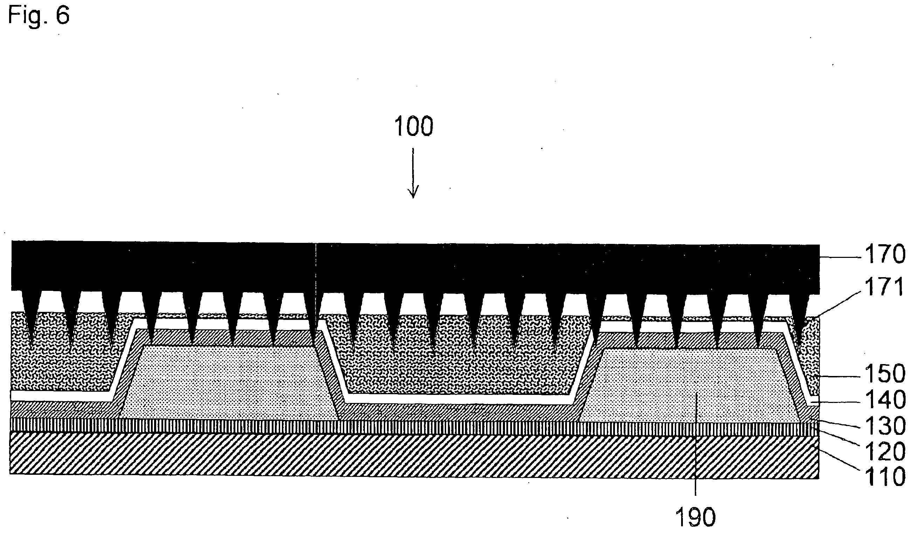

Fig. 6 zeigt eine ähnliche nicht beanspruchte Ausführungsform der Erfindung, die ein erfindungsgemäßes Bauelement für Beleuchtungsanwendungen zeigt, bei welchem Abstandshalter 190 eingeführt sind um eine Schädigung der organischen Schichtstruktur 130 zu vermeiden. Wiederum müssen die Abstandshalter insbesondere mechanisch so ausgelegt sein, dass sie der mechanischen Belastung bei dem Prägevorgang zur Erzeugung der optisch aktiven Heterogenitäten in der äußeren Oberfläche der Zusatzschicht standhalten.

Das Stempeln von nasschemisch hergestellten Auskoppelschichten erfolgt je nach Ausführungsform vor, während oder nach dem Aushärten der Schicht. Im erstgenannten Fall ist die mechanische Belastung für die organische Schichtenstruktur am geringsten.

Ein schonendes nicht beanspruchtes Verfahren beim Strukturieren der Zusatzschicht wird mittels einer an das Siebdruckverfahren angelehnten Technik ausgeführt. Hierbei wird zuerst eine der obenstehend angegebenen nasschemisch erzeugten Schichten auf die zweite Elektrode des Bauelementes aufgebracht und diese durch Auflegung und Andrücken eines Gewebes strukturiert. Zum Andrücken des Gewebes findet u.a. das im Siebdruckverfahren gängige Rakeln, beispielsweise unter Verwendung von Polyurethanrakeln Verwendung. In einer weiteren nicht beanspruchten Ausführungsform wird durch das Gewebe eine weitere Schicht nasschemisch aufgerakelt, was ein Anlösen der darunter liegenden Schicht bewirkt und so die Strukturierung erleichtert. In allen Fällen ist darauf zu achten, dass die Verformung dauerhaft auch nach dem Aushärten der Auskoppelschicht bestehen bleibt.

Wie schon erläutert, erfolgt in anderen Ausführungsformen das Aufrauen der Auskoppelschicht auf nichtmechanischem Wege. Diese Verfahren bietet sich insbesondere dann an, wenn die Auskoppelschicht sehr dünn oder sehr weich ist, sodass kein ausreichender mechanischer Schutz für die darunter liegenden organischen Schichten bereitgestellt werden kann. Mögliche Verformgebungsverfahren der Oberfläche der Zusatzschicht sind:
- reaktives Trockenätzen
- nichtreaktives Trockenätzen
- nasschemisches Ätzen, z.B. mit Säuren
- Photolithographische Strukturierung

Insbesondere bei extrem empfindlicher organischer Schichtstruktur erfolgt die Aufrauung der Auskoppelschicht bevor diese auf das Bauelement aufgebracht wird. Damit kann die mechanische, thermisch, strahlende und/oder chemische Belastung des Bauelementes deutlich vermindert werden. Dieses vorteilhafte Verfahren wird beispielsweise erreicht durch Auflaminieren eines vorstrukturierten Laminierfilms. Dabei wird zunächst ein transparenter oder semitransparenter Laminierfilm aus einem der obenstehend angegebenen Lösungsmittelmaterialien prozessiert. Dieser wird nachfolgend mit einem der oben angegebenen mechanischen oder nichtmechanischen Verfahren an dessen Oberfläche so strukturiert, dass seine Vorderseite aufgeraut ist, wodurch die

Totalreflexion im Film und damit die Ausbildung von Organik-/Elektroden-Moden im Bauteil verhindert oder vermindert wird. Das Auflaminieren des Films auf dem Bauelement erfolgt so, dass die glatte Rückseite mit dem Bauelement, in der Regel mit der zweiten Elektrode, verbunden wird.

Bei einem solchen beispielhaften Bauelement besteht der Laminierfilm aus Polyvinylacetat, der durch Schleifen aufgeraut wird und dann mit der glatten Seite auf die transparente Elektrode, d.h. die Top-Elektrode laminiert oder geklebt wird. Mit einem derartig hergestellten Bauelement erhöht sich die Effizienz um bis zu 300 %.

Bei einer nicht dargestellten Ausführungsform ist die Zusatzschicht in Form einer vorstrukturierten Folie mittels eines Klebers auf der glatten Seite auf die transparente Top-Elektrode des Bauelementes aufgeklebt. Der Kleber ist dabei hochtransparent und von seinen Eigenschaften so gewählt, dass er die organischen Schichten gut verkapselt. Dies stellt einen ausreichend guten Schutz gegen Umwelteinflüsse bereit, ferner kann so auf eine zusätzliche Verkapselung der OLED verzichtet werden. Je nach Ausführungsform kann die Strukturierung des Films verschiedene Formen aufweisen, besonders vorteilhaft ist eine Strukturierung des Films mit dachförmigen Streifen und einer Höhe zwischen 1 µm und 100 µm ausgebildet. Darüber hinaus kann die Strukturierung auch flächig sein, beispielsweise durch pyramidenförmige Strukturen.

In einer weiteren nicht beanspruchten Ausführungsform ist die Auskopplungsschicht auf die transparente Top-Elektrode als organische Schicht aus Bphen aufgedampft. Die Streuzentren in der Auskopplungsschicht werden dadurch gebildet, dass Bphen selbst teilauskristallisiert. Um die Organik-Schichten vor Umwelteinflüssen zu schützen, ist eine zusätzliche Verkapselung mit einer dünnen Glasscheibe vorgesehen. Zur Vermeidung eines Einflusses dieser Glasscheibe auf die Lichtauskopplung ist die

Verkapselung-Glasscheibe in einem ausreichenden Abstand zur Auskoppelschicht angebracht, sodass die Glasscheibe lediglich als planparallele Platte wirkt.

### Bezugszeichenliste

- 100: OLED-Bauelement
- 110: Substrat
- 120: Erste Elektrode
- 130: Organische Schicht/Schichtstruktur
- 140: Zweite Elektrode
- 150: Auskoppelschicht
- 151: Streupartikel
- 152: Rille, Furche
- 153: Ausnehmung
- 160: Isolationsmaterial
- 170: Stempel
- 171: Schneide
- 172, 173: Schneidfläche, Stempelfläche
- 180: Separator
- 190: Abstandshalter
- EM1, EM2,: Externe Moden
- OM1: Organik-Mode
- S: Stempelkraft
- F1, F2: Kraftrichtung in Zusatzschicht

## Patentansprüche

1. Top-emittierendes, elektrolumineszierendes Bauelement, umfassend ein Substrat, eine zum Substrat nächstliegende erste Elektrode, eine zum Substrat entfernt gelegene zweite Elektrode und zumindest eine zwischen beiden Elektroden angeordnete Licht emittierende organische Schicht, wobei emittiertes Licht durch die zweite Elektrode hindurch transmittiert, auf der Seite der zweiten Elektrode (140), welche der zumindest einen organischen Schicht (130) abgewandt ist, eine Zusatzschicht angeordnet ist, welche optisch wirksame, Licht streuende Heterogenitäten aufweist, wobei der Transmissionsgrad der Zusatzschicht bei der Wellenlänge des emittierten Lichtes größer 0,6 beträgt und wobei die Zusatzschicht an der zweiten Elektrode (140) anliegt und mit dieser verbunden ist, **dadurch gekennzeichnet, dass** die optisch wirksamen, Licht streuenden Heterogenitäten als Versetzungsgrenzen einzelner mikrokristalliner Bereiche in dem Material der Zusatzschicht gebildet sind, wobei die Zusatzschicht aus einer Gruppe II-VI-Halbleiterverbindung, einer Gruppe III-Nitrid-Halbleiterverbindung, zwei unterschiedlichen Gruppe II-VI-Halbleiterverbindungen, die abwechselnd angeordnet sind, oder zwei unterschiedlichen Gruppe III-Nitrid-Halbleiterverbindungen die abwechselnd angeordnet sind, besteht.

2. Bauelement nach Anspruch 1, **dadurch gekennzeichnet, dass** die Heterogenitäten eine Größe von etwa 0,05µm bis 100µm aufweisen.

3. Bauelement nach einem der vorangehenden Ansprüche, **dadurch gekennzeichnet, dass** die Heterogenitäten innerhalb und an der Oberfläche der Zusatzschicht angeordnet sind.

4. Bauelement nach einem der vorangehenden Ansprüche, **dadurch gekennzeichnet, dass** die Dicke der zweiten Elektrode (140) weniger als 200nm beträgt und der Brechungsindex der Zusatzschicht größer als der Brechungsindex der nächstgelegenen, zwischen den Elektroden angeordneten organischen Schicht ist.

5. Bauelement nach einem der vorangehenden Ansprüche, **dadurch gekennzeichnet, dass** der Brechungsindex der Zusatzschicht größer als der Brechungsindex der zweiten Elektrode (140) ist.

6. Bauelement nach einem der vorangehenden Ansprüche, **dadurch gekennzeichnet, dass** der Brechungsindex der Zusatzschicht zwischen 1.3 und 2.3 liegt.

7. Bauelement nach einem der vorangehenden Ansprüche, **dadurch gekennzeichnet, dass** die zur Zusatzschicht nächstgelegene, zwischen den Elektroden angeordnete organische Schicht eine Löchertransportschicht ist, die mit einem akzeptorartigen organischen Material p-dotiert ist und eine Dicke zwischen 50nm und 2µm aufweist.

8. Bauelement nach einem der Ansprüche 1 bis 6, **dadurch gekennzeichnet, dass** die zur Zusatzschicht nächstgelegene, zwischen den Elektroden angeordnete organische Schicht eine Elektronentransportschicht ist, die mit einem donatorartigen organischen Material n-dotiert ist und eine Dicke zwischen 50nm und 2µm aufweist.

9. Bauelement nach einem der vorangehenden Ansprüche, **dadurch gekennzeichnet, dass** die Zusatzschicht eine Dicke zwischen 50nm und 1000µm aufweist.

10. Bauelement nach einem der vorangehenden Ansprüche, **dadurch gekennzeichnet, dass** mit der Zusatzschicht ein Schutz für die zwischen den Elektroden angeordneten Schichten gegen mechanische Belastungen, elektromagnetische Strahlungen, Teilchenstrahlung wie α/β-Strahlung, Feuchtigkeit, Luft und/oder chemische Einflüsse gebildet ist.

11. Verfahren zur Herstellung eines top-emittierenden, elektrolumineszierenden Bauelementes bei der eine erste Elektrode nächstliegend zu einem Substrat, eine zum Substrat entfernt gelegene zweite Elektrode und zumindest eine zwischen beiden Elektroden liegende, Licht emittierende organische Schicht gebildet werden, wobei emittiertes Licht durch die zweite Elektrode hindurch geführt wird und auf der Seite der zweiten Elektrode (140), welche der zumindest einen organischen Schicht (130) abgewandt ist, eine Zusatzschicht mit optisch wirksamen, Licht streuenden Heterogenitäten auf die zweite Elektrode (140) aufgebracht wird, derart, dass die Zusatzschicht an der zweiten Elektrode (140) anliegt und mit dieser verbunden ist, **dadurch gekennzeichnet, dass** das Material der Zusatzschicht aus einer Gasphase abgeschieden und mittels thermischen Verdampfens im Vakuum auf die zweite Elektrode aufgebracht wird, derart, dass die optisch wirksamen, Licht streuenden Heterogenitäten als Versetzungsgrenzen einzelner mikrokristalliner Bereiche in dem Material der Zusatzschicht gebildet werden, wobei die Zusatzschicht aus einer Gruppe II-VI-Halbleiterverbindung, einer Gruppe III-Nitrid-Halbleiterverbindung, zwei unterschiedlichen Gruppe II-VI-Halbleiterverbindungen, die abwechselnd abgeschieden werden, oder zwei unterschiedlichen Gruppe III-Nitrid-Halbleiterverbindungen, die abwechselnd abgeschieden werden, geformt wird.

12. Verfahren nach Anspruch 11, **dadurch gekennzeichnet, dass** Prozessparameter zur Ausbildung von polykristallinen Mikrostrukturen und Versetzungen derart gewählt werden, dass zur Verstärkung des Auftretens von polykristallinem Wachstum und/oder Versetzungsgrenzen in der Zusatzschicht unterschiedliche Materialien mit unterschiedlichen Gitterkonstanten aufgedampft werden.

13. Verfahren nach einem der Ansprüche 11 oder 12, **dadurch gekennzeichnet, dass** zwischen der zumindest einen Licht emittierenden organischen Schicht und der zweiten Elektrode eine zwischen 100nm und 1000nm dicke und eine organischen Dotierung aufweisende Transportschicht aufgebracht wird.

## Claims

1. A top-emitting, electroluminescent component, comprising a substrate, a first electrode nearest to the substrate, a second electrode at a distance from the substrate and at least one light-emitting organic layer arranged between the two electrodes, emitted light being transmitted through the second electrode, wherein an additional layer (150) is arranged on a side of the second electrode which is facing away from the at least one organic layer (130), wherein the additional layer (150) has optically effective, light-scattering heterogeneities (151, 152, 153), wherein the degree of transmission of the additional layer at the wavelength of the emitted light is greater than 0.6, and wherein the additional layer (150) is adjacent to and connected to the second electrode (140), **characterized in that** the optically effective, light-scattering heterogeneities are formed as offsetting limits of individual microcrystalline areas in the material of the additional layer, wherein the additional layer consists of a group II-IV-semiconductor compound, a group III-nitride semiconductor compound, two different group II-IV-semiconductor compounds, which are arranged alternately, or two different group III-nitride semiconductor compounds, which are arranged alternately.

2. The component according to Claim 1, **characterized in that** heterogeneities have a size of around 0.05 µm to 100 µm.

3. The component according to any one of the preceding claims, **characterized in that** the heterogeneities are arranged within and on the surface of the additional layer.

4. The component according to any one of the preceding claims, **characterized in that** the thickness of the second electrode (140) is less than 200 nm and the refractive index of the additional layer (150) is greater than the refractive index of the nearest organic layer arranged between the electrodes.

5. The component according to any one of the preceding claims, **characterized in that** the refractive index of the additional layer (150) is greater than the refractive index of the second electrode (140).

6. The component according to any one of the preceding claims, **characterized in that** the refractive index of the additional layer (150) is between 1.3 and 2.3.

7. The component according to any one of the preceding claims, **characterized in that** the organic layer nearest to the additional layer and arranged between the electrodes is a hole transport layer, which is p-doped with an acceptor-like organic material and has a thickness of between 50 nm and 2 µm.

8. The component according to any one of Claims 1 to 6, **characterized in that** organic layer nearest to the additional layer and arranged between the electrodes is an electron transport layer, which is n-doped with a donor-type organic material and has a thickness of between 50 nm and 2 µm.

9. The component according to any one of the preceding claims, **characterized in that** the additional layer (150) has a thickness of between 50 nm and 1000 µm.

10. The component according to any one of the preceding claims, **characterized in that** the additional layer (150) is built up in such a way that it provides protection for the layers arranged between the electrodes against mechanical loads, electromagnetic radiation, particle radiation such as α/β radiation, moisture, air and/or chemical influences.

11. A method of manufacturing a top-emitting, electroluminescent component, in which is arranged a first electrode nearest to a substrate, a second electrode at a distance from the substrate and at least one light-emitting layer lying between the electrodes, emitted light being led through the second electrode, wherein on a side of the second electrode (140), which is facing away from the at least one organic layer (130), an additional layer (150) with optically effective, light-scattering heterogeneities (151, 152, 153) is applied, and wherein the additional layer (150) is adjacent to and connected to the second electrode (140), **characterized in that** the material of the additional layer is deposited from a gaseous phase and is applied to the second electrode by a vapour deposition in vacuum such that the optically effective, light-scattering heterogeneities are formed as offsetting limits of individual microcrystalline areas in the material of the additional layer, wherein the additional layer consists of a group II-IV-semiconductor compound, a group III-nitride semiconductor compound, two different group II-IV-semiconductor compounds, which are deposited alternately, or two different group III-nitride semiconductor compounds, which are deposited alternately.

12. The method according to Claim 11, **characterized in that** process parameters are selected so that the formation of polycrystalline microstructures and offset structures are promoted in order to intensify the occurrence of polycrystalline growth and/or offsetting limits in the additional layer various materials with different lattice constants are vapour deposited.

13. The method according to claim 11 or 12, **characterized in that** between the at least one light-emitting organic layer and the second electrode, a transport layer exhibiting organic-doping and having a thickness between 100 nm and 1000 nm is applied.

## Revendications

1. Composant électroluminescent, émettant par le haut, comprenant un substrat, une première électrode la plus proche du substrat, une deuxième électrode éloignée du substrat et au moins une couche organique émettant de la lumière disposée entre les deux électrodes, dans lequel la lumière est émise à travers la deuxième électrode, sur le côté de la deuxième électrode (140), qui se détourne d'au moins une couche organique (130), une couche supplémentaire est disposée, qui présente des hétérogénéités optiquement efficaces, diffusant la lumière, dans lequel le degré de transmission de la couche supplémentaire à la longueur d'onde de la lumière émise est supérieure à 0,6 et dans lequel la couche supplémentaire vient reposer sur la deuxième électrode (140) et est reliée avec celle-ci, **caractérisé en ce que** les hétérogénéités optiquement efficaces, diffusant la lumière sont formées comme des limites de dislocations de zones microcristallines individuelles dans le matériau de la couche supplémentaire, dans lequel la couche supplémentaire est constituée d'un groupe de composé semi-conducteur II-VI, d'un groupe de composé semi-conducteur de nitrure III de deux groupes différents de composés semi-conducteurs II-VI, qui sont disposés en alternance, ou deux groupes différents de composés semi-conducteurs de nitrure III, qui sont disposés en alternance.

2. Composant selon la revendication 1, **caractérisé en ce que** les hétérogénéités présentent une taille d'approximativement 0,05 µm à 100 µm.

3. Composant selon une des revendications précédentes, **caractérisé en ce que** les hétérogénéités sont disposées à l'intérieur et sur la surface de la couche supplémentaire.

4. Composant selon une des revendications précédentes, **caractérisé en ce que** l'épaisseur de la deuxième électrode (140) est inférieure à 200 nm et l'index de réfraction de la couche supplémentaire est plus grand que l'index de réfraction de la couche organique disposée le plus près entre les électrodes.

5. Composant selon une des revendications précédentes, **caractérisé en ce que** l'index de réfraction de la couche supplémentaire est plus grand que l'index de réfraction de la deuxième électrode (140).

6. Composant selon une des revendications précédentes, **caractérisé en ce que** l'index de réfraction de la couche supplémentaire est compris entre 1.3 et 2.3.

7. Composant selon une des revendications précédentes, **caractérisé en ce que** la couche organique disposée entre les électrodes, la plus proche de la couche supplémentaire est une couche de transport à trous, qui est p-dopée avec un matériau organique de type accepteur et présente une épaisseur comprise entre 50 nm et 2 µm.

8. Composant selon une des revendications 1 à 6, **caractérisé en ce que** la couche organique disposée entre les électrodes, la plus proche de la couche supplémentaire est une couche de transport d'électrons, qui est n-dopée avec un matériau organique de type donateur et présente une épaisseur comprise entre 50 nm et 2 µm.

9. Composant selon une des revendications précédentes, **caractérisé en ce que** la couche supplémentaire présente une épaisseur comprise entre 50 nm et 1000 µm.

10. Composant selon une des revendications précédentes, **caractérisé en ce que** avec la couche supplémentaire est formée une protection des couches disposées entre les électrodes contre des charges mécaniques, rayonnements électromagnétiques, rayonnement de particules comme rayonnement α/β, humidité, air et/ou influences chimiques.

11. Procédé de fabrication d'un composant électroluminescent, émettant par le haut, dans lequel une première électrode la plus proche d'un substrat, une deuxième électrode éloignée du substrat et au moins une couche organique émettant de la lumière disposée entre les deux électrodes sont formées, dans lequel la lumière émise par la deuxième électrode est guidée à travers et sur le côté de la deuxième électrode (140), qui se détourne d'au moins une couche organique (130), une couche supplémentaire, qui présente des hétérogénéités optiquement efficaces, diffusant la lumière est appliquée sur la deuxième électrode (140), dans lequel la couche supplémentaire vient reposer sur la deuxième électrode (140) et est reliée avec celle-ci, **caractérisé en ce que** le matériau de la couche supplémentaire est séparé à partir d'une phase gazeuse et est appliqué au moyen d'une évaporation thermique sous vide sur la deuxième électrode, de telle sorte que les hétérogénéités optiquement efficaces, diffusant la lumière soient formées comme des limites de dislocations de zones microcristallines individuelles dans le matériau de la couche supplémentaire, dans lequel la couche supplémentaire est formée d'un groupe de composé semi-conducteur de groupe II-VI, d'un groupe de composé semi-conducteur de nitrure de groupe III de deux groupes différentes de composés semi-conducteurs II-VI, qui sont disposés en alternance, ou deux groupes différents de composés semi-conducteurs de nitrure III, qui sont disposés en alternance.

12. Procédé selon la revendication 11, **caractérisé en ce que** les paramètres de processus pour réaliser des microstructures polycristallines et des dislocations sont sélectionnés de telle sorte que pour renforcer l'apparition d'une croissance polycristalline et/ou des limites de dislocation dans la couche supplémentaire, des matériaux différents dans la couche supplémentaire sont déposés en phase vapeur avec des constantes de réseau différentes.

13. Procédé selon une des revendications 11 ou 12, **caractérisé en ce que** entre au moins une couche organique émettant de la lumière et la deuxième électrode, une couche de transport d'une épaisseur comprise entre 100 nm et 1000 nm et présentant un dopage organique est appliquée.
